Europäisches Patentamt

European Patent Office

Office européen des brevets

(19)

(11) **EP 0 635 941 B1**

(12) **FASCICULE DE BREVET EUROPEEN**

(45) Date de publication et mention
de la délivrance du brevet:
**01.10.1997  Bulletin 1997/40**

(51) Int Cl.⁶: **H03K 5/22**, H03K 5/26,
H04L 7/02

(21) Numéro de dépôt: **94401541.1**

(22) Date de dépôt: **05.07.1994**

(54) **Système électronique à recalage d'horloge**

Elektronisches System zur Neusynchronisierung von Taktsignalen

Electronic system for clock resynchronisation

(84) Etats contractants désignés:
**AT BE CH DE DK ES GB GR IE IT LI LU MC NL PT
SE**

(30) Priorité: **22.07.1993  FR 9309010**

(43) Date de publication de la demande:
**25.01.1995  Bulletin 1995/04**

(73) Titulaire: **SOCIETE D'APPLICATIONS
GENERALES
D'ELECTRICITE ET DE MECANIQUE SAGEM
F-75783 Paris Cédex 16 (FR)**

(72) Inventeur: **Perrot, Thierry
F-93800 Epinay sur Seine (FR)**

(74) Mandataire: **Bloch, Gérard et al
2, square de l'Avenue du Bois
75116 Paris (FR)**

(56) Documents cités:
**EP-A- 0 048 896         EP-A- 0 124 674
US-A- 3 418 637**

- **IBM TECHNICAL DISCLOSURE BULLETIN,
  vol.31, no.7, Décembre 1988, ARMONK, US
  pages 455 - 458, XP000031763 'Feed-Forward
  Compensation Circuit for Digital Random-Walk
  Filters'**
- **PATENT ABSTRACTS OF JAPAN vol. 7, no. 288
  (E-218) (1433) 22 Décembre 1983 & JP-A-58 164
  311**

## Description

Le domaine de la présente invention est celui des horloges dont disposent les systèmes électroniques et notamment les systèmes numériques synchrones. Pour fixer les idées, et sans que cela doive être considéré comme une limitation de la portée de la présente demande, précisons que c'est à propos de l'horloge des terminaux portatifs de téléphonie cellulaire que la demanderesse s'est posé le problème qui est à l'origine de son invention et qui va être exposé ci-après. Il faut encore préciser, à titre liminaire, que la qualité d'une horloge, au sens de la présente demande, est la précision en fréquence de son signal d'horloge ou la précision de la période selon laquelle elle délivre ses tops d'horloge. A cet égard, il existe des horloges très performantes et même des horloges idéales, ou de référence, et puis aussi des moins performantes. A titre d'exemple, pour une montre électronique, une horloge à quartz est naturellement moins bonne qu'une horloge atomique.

Une horloge idéale est d'un coût prohibitif et les systèmes électroniques en sont rarement pourvus. Au contraire, on y intègre une horloge de performances moyennes, dont la période n'est pas parfaite, mais on recale régulièrement ces systèmes sur une horloge de référence externe, pour compenser l'imprécision, c'est-à-dire réduire l'erreur de l'horloge interne.

Pour reprendre l'exemple ci-dessus, un terminal portatif de téléphonie, comprenant une horloge interne, est régulièrement recalé sur l'horloge de référence d'une borne du réseau cellulaire.

Mais le recalage d'un système électronique sur une horloge de référence externe est également d'un coût important, notamment en énergie. C'est pourquoi on a toujours cherché à ne procéder aux recalages que par périodes très longues.

C'est ainsi que la demanderesse a voulu proposer sa propre solution à ce problème de recalage d'horloge.

On comprendra facilement que ce problème revêt toute son importance dans les systèmes numériques, surtout s'il s'agit de télépnonie. Toutefois, la demanderesse n'entend nullement limiter la portée de son invention à de tels systèmes numériques.

La demanderesse a donc considéré un système électronique comprenant une horloge interne, fournissant un signal de période T1 imprécise à une base de temps, et des moyens de recalage d'horloge, agencés pour, en combinaison avec une horloge externe de référence fournissant un signal de période To, compenser l'imprécision de la période T1 du signal de l'horloge interne.

Le système de la présente demande est caractérisé par le fait que les moyens de recalage d'horloge sont agencés pour déterminer le nombre N de périodes T1 du signal de l'horloge interne pendant lesquelles le signal de l'horloge interne a subi une dérive d'une période To par rapport au signal de référence et pour fournir à la base de temps un signal, de période NT1, d'impulsions destinées à retarder, d'une durée PTo, le signal d'horloge interne fourni par la base de temps, P étant un nombre égal ou supérieur à 1.

On remarquera d'emblée que le retard dont il s'agit est un retard algébrique, la dérive déterminée par les moyens de recalage, ou réducteur d'erreur, pouvant être d'une période de référence To, dans un sens ou dans l'autre.

L'invention est remarquable par sa simplicité puisqu'il suffit essentiellement de déterminer une dérive To et un nombre N de périodes du signal de l'horloge interne.

Dans la forme de réalisation préférée du système de l'invention, les moyens de recalage d'horloge comprennent des moyens de détermination du nombre N de périodes T1 au terme desquelles le signal de l'horloge interne a dérivé d'une période To par rapport au signal de référence et des moyens de détermination du sens de la dérive.

Grâce à cela, les fonctions de détermination des moyens de recalage sont assurées de façon distincte avec une meilleure précision.

Avantageusement, les moyens de détermination du sens de la dérive des moyens de recalage comprennent une horloge auxiliaire de période 3T1 triple de celle de l'horloge interne, des moyens de création d'une triple fenêtre temporelle de largeur 3To, avec une fenêtre centrale et deux fenêtres latérales, chacune d'une largeur To, et un front montant du signal de l'horloge auxiliaire dans la fenêtre centrale au début de la période de détermination, et des moyens de détection du front montant considéré du signal de l'horloge auxiliaire dans l'une ou l'autre des deux fenêtres latérales de la triple fenêtre.

Si le front montant est détecté dans la fenêtre supérieure droite, cela signifie que le signal de l'horloge interne dérive, par rapport au signal de référence, vers la droite sur l'axe des temps, c'est-à-dire que la dérive est positive, la période T1 étant supérieure à la période de référence To. Si le front montant est détecté dans la fenêtre inférieure gauche, c'est que la dérive est négative.

Les moyens de recalage d'horloge peuvent être agencés pour, à partir du signal de retardement, compenser la dérive et recaler, toutes les N périodes T1, le signal de l'horloge interne de la dérive d'amplitude To, c'est-à-dire à chaque impulsion du signal de retardement (P = 1).

Les moyens de recalage d'horloge peuvent aussi être agencés pour, à partir du signal de retardement, recaler toutes les PN périodes T1, le signal de l'horloge interne d'une dérive d'amplitude PTo, P étant un nombre entier constant, c'est-à-dire toutes les P impulsions du signal de retardement (P>1 et constant).

Les moyens de recalage d'horloge peuvent enfin être agencés pour, à partir du signal de retardement, compenser la dérive de manière asynchrone et recaler, toutes les PN périodes T1, le signal de l'horloge interne d'une dérive d'amplitude PTo, P étant un nombre entier variable, c'est-à-dire toutes les P impulsions du signal de retardement (P>1 et variable).

L'invention sera mieux comprise à l'aide des explications et de la description du système de l'invention qui suivent, en référence au dessin annexé, sur lequel

- les figures 1A et 1B représentent les signaux des horloges externe et interne, respectivement, du système électronique de l'invention ;

- les figures 2A et 2B représentent, respectivement, un signal d'horloge auxiliaire interne et le signal de l'horloge externe de référence ;

- la figure 3 représente le signal d'impulsions de recalage d'horloge et

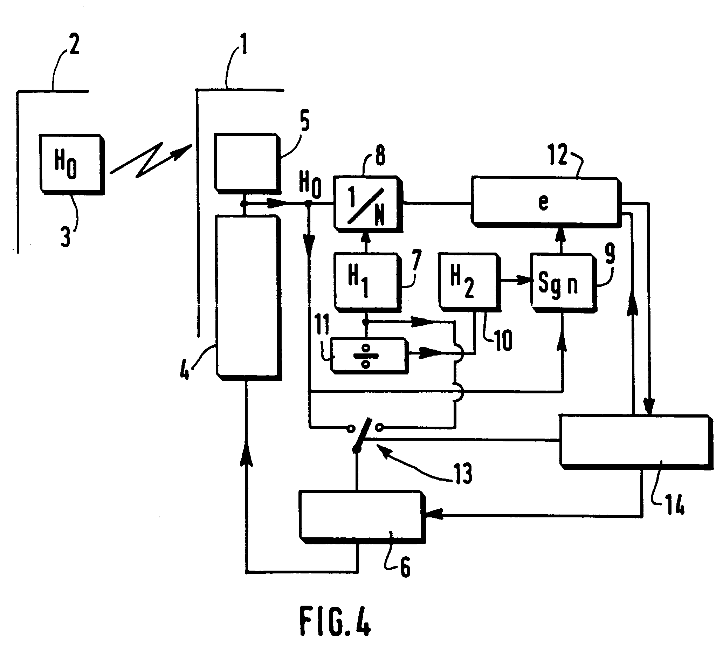

- la figure 4 est une représentation schématique d'un terminal portatif de téléphonie à recalage d'horloge selon l'invention.

## Théorie de l'invention

Soit T1 la période du signal logique $H_1$ d'une horloge interne d'un système électronique, tel, par exemple, un terminal portatif de téléphonie d'un réseau cellulaire, To la période du signal logique Ho d'une horloge de référence externe, telle l'horloge d'une des bornes du réseau cellulaire, et e l'erreur relative de T1 par rapport à To :

$$T1 = To (1 + e)$$

$$T1 - To = e\ To$$

$$e = \frac{T1 - To}{To}$$

e est l'imprécision ou l'erreur qui est à compenser ou réduire, tant en amplitude

$$|e| = \frac{|T1\ To|}{To}$$

qu'en signe Sgn(e).

Considérons, pour le signal H1, une fenêtre temporelle F correspondant à une période To du signal de référence Ho et, dans cette fenêtre, le front montant u du signal H1.

Si T1 > To, donc si e > o ou si Sgn (e) est PLUS, le front montant u apparaissant au cours du temps dans la fenêtre F va dériver vers la droite sur l'axe des temps. Au contraire, si T1 < To, donc si e < o ou si Sgn (e) est MOINS, le front montant va dériver vers la gauche sur l'axe des temps.

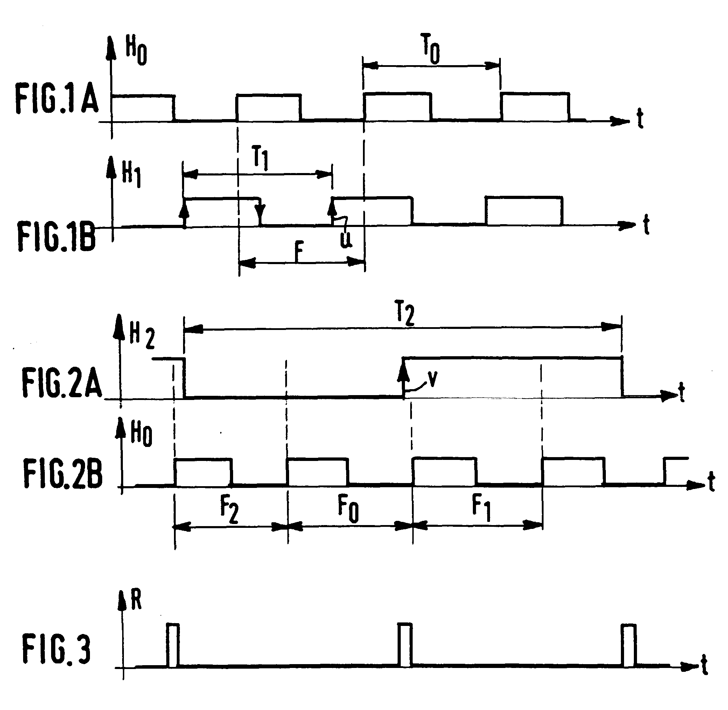

Sur les figures 1A, 1B, par exemple, l'erreur e est positive.

## détermination de |e|

On attend l'instant où un front montant u du signal H1 passe par l'un des deux bords de la fenêtre F, puis on compte le nombre de fronts montants ayant traversé la fenêtre F jusqu'à ce qu'un prochain front montant u passe par l'autre des deux bords de la fenêtre F. Il s'est alors écoulé N périodes T1 du signal H1 qui, pendant ces N périodes, a donc dérivé d'une période To, dans un sens ou dans l'autre, le sens de la dérive étant ici indifférent.

Comme à chaque période du signal H1, l'amplitude de l'erreur, ou du décalage, entre les signaux H1 et Ho est égale à |T1 - To| et qu'au terme des N périodes considérées, l'amplitude du décalage est égale à To, on peut écrire, aux erreurs de mesure près,

$$N\ |T1 - To| = To$$

soit

$$NTo\ |e| = To$$

$$|e| = \frac{1}{N}$$

L'amplitude de l'erreur relative |e| est donc égale à l'inverse du nombre N de périodes T1 du signal H1 au terme desquelles le signal de l'horloge interne a dérivé d'une période To du signal de référence Ho par rapport à ce signal Ho.

## détermination de Sgn(e)

Le système électronique comporte une horloge interne auxiliaire délivrant un signal H2 de période 3T1 (figure 2A).

Considérons, pour le signal H2, une triple fenêtre temporelle de largeur 3To, avec une fenêtre centrale Fo, de largeur To, une fenêtre latérale droite F1, de largeur To, et une fenêtre latérale gauche F2, de largeur To (figure 2B). Considérons le front montant ʊ du signal H2 qui se trouve, par définition de la fenêtre centrale Fo, dans cette fenêtre, au début du processus de détermination. Naturellement, par rapport au signal Ho, le signal H2, au cours du temps, et par construction, dérive avec le signal H1. Si, hors de cette fenêtre centrale Fo, on détecte ensuite ce front montant ʊ dans la fenêtre F1, à droite de la fenêtre Fo, cela signifie que le signal H2, et, avec lui, le signal H1, dérivent vers la droite sur l'axe des temps et que, par conséquent, la dérive ou l'erreur est positive : Sgn(e), POSITIF. Sinon, c'est-à-dire si le front montant est détecté dans la fenêtre F2, c'est l'inverse, l'erreur est négative : Sgn(e), NEGATIF.

Recalage

Soit donc le signal R d'impulsions espacées de périodes NT1 (figure 3). Le signal H1 peut être retardé, à chaque impulsion du signal R, d'une période d'amplitude To et de signe Sgn(e).

Mais le signal H1 pourrait aussi n'être retardé que toutes les P impulsions du signal R, d'une durée d'amplitude PTo et de signe Sgn(e), P étant une constante. Dans ce cas, il s'agit d'une compensation différée.

Le signal H1 pourrait encore n'être retardé que toutes les P impulsions du signal R, d'une durée d'amplitude de PTo et de signe Sgn (e), mais P étant une variable. Dans ce cas, il s'agit d'une compensation différée asynchrone.

Réalisation pratique

Comme système électronique, on considérera ici un terminal portatif de téléphonie 1 pouvant communiquer avec une des bornes 2 d'un réseau cellulaire, du type GSM. La borne 2 dispose d'une horloge de référence 3 délivrant un signal Ho de période très précise.

Le terminal 1 comporte des circuits d'exploitation 4, un émetteur-récepteur 5 et une base de temps 6, pour les circuits 4, pilotée par un quartz classique 7 délivrant un signal H1. La période du signal H1 n'est pas parfaitement précise et l'imprécision est corrigée grâce à l'horloge 3 de la borne 2 ainsi qu'à des éléments de recalage d'horloge qui vont être décrits ci-après.

Le terminal 1 comporte un circuit 8, comportant un compteur modulo N, recevant les signaux Ho et H1, de détermination, comme expliqué plus haut, du nombre N de périodes du signal H1, au terme desquelles le signal H1 a dérivé d'une période du signal Ho par rapport à ce signal Ho.

Le terminal 1 comporte également un circuit 9 recevant le signal H0 et un signal H2, de période triple de celle du signal H1, d'une horloge 10 reliée au quartz 7 par un diviseur de fréquence 11. Le circuit 9 détermine, comme également expliqué plus haut, le sens de la dérive du signal H1.

La base de temps 6 est finalement pilotée par le quartz 7, l'horloge de référence 3 et un circuit de correction 12 recevant les signaux d'amplitude d'erreur $\frac{1}{N}$ et de signe d'erreur Sgn.

La base de temps 6 est un compteur binaire, ici agencé pour compter jusqu'à $2^{14}$, relié, en entrée, à un commutateur 13 commandé par le circuit 12, par l'intermédiaire d'un contrôleur de correction 14 qui contrôle également le compteur 6, et permettant de commuter l'entrée de la base de temps soit sur l'horloge 3, soit sur le quartz 7. Le compteur 6 est normalement commuté sur le quartz 7 ; pendant les étapes de détermination décrites ci-dessus, le compteur 6 est commuté sur l'horloge de référence 3.

L'horloge H1 commande la base de temps 6 qui peut fournir un signal d'horloge H1, mais aussi et, en fait, un autre signal H'1 ici de période multiple de H1. Dans la présentation ci-dessus de l'invention, on a assimilé H1 et H'1. Il est clair qu'on n'agit pas sur le quartz 7 fournissant le signal H1 mais bien sur la base de temps 6.

A l'étape de correction, le contrôleur 14 commute le compteur 6 sur le quartz 7 et commande le circuit 12 qui, par son intermédiaire, va agir sur le signal de sortie du compteur 6.

Considérons une compensation synchrone différée de P périodes du signal H1 et une remise à zéro prédéterminée du compteur 6 dans un état de comptage C. Lorsque le contrôleur 14 a détecté P impulsions de retardement du circuit 12, il fait passer sa valeur de remise à zéro à C + P, dans le cas où Sgn est NEGATIF, ou C - P, dans le cas où Sgn est POSIFIF.

Au cycle suivant du compteur 6, sa valeur de remise à zéro repasse à C.

En cas de compensation différée asynchrone, le contrôleur 14, à un instant quelconque, et à priori entre deux impulsions de retardement, détermine le nombre d'impulsions de retardement reçues du circuit 12 et agit sur la valeur de remise à zéro du compteur 6 comme précédemment. Il en résulte bien sûr une erreur mais l'exploitation est sensiblement moins contraignante.

**Revendications**

1. Système électronique (1) comprenant une horloge interne (7), fournissant un signal de période T1 imprécise à une base de temps (6), et des moyens (8-14) de recalage d'horloge, agencés pour, en combinaison avec une horloge externe de référence (3) fournissant un signal de période To, compenser l'imprécision de la période T1 du signal de l'horloge interne (7), caractérisé par le fait que les moyens de recalage d'horloge sont agencés pour déterminer le nombre N de périodes T1 du signal de l'horloge interne (7) pendant lesquelles le signal de l'horloge interne (7) a subi une dérive d'une période To par rapport au signal de référence et pour fournir à la base de temps (6) un signal, de période NT1, d'impulsions destinées à retarder, d'une durée PTo, le signal d'horloge fourni par la base de temps (6), P étant un nombre entier égal ou supérieur à 1.

2. Système selon la revendication 1, dans lequel les moyens de recalage d'horloge comprennent des moyens (8) de détermination du nombre N de périodes T1 au terme desquelles le signal de l'horloge interne (7) a dérivé d'une période To par rapport au signal de référence et des moyens (9-11) de détermination du sens de la dérive.

3. Système selon la revendication 2, dans lequel les moyens de détermination du sens de la dérive des moyens de recalage comprennent une horloge auxiliaire (10) de période 3T1 triple de celle de l'horloge interne (7), des moyens (9) de création d'une triple fenêtre temporelle de largeur 3To, avec une fenêtre centrale et deux fenêtres latérales, chacune d'une largeur To, et un front montant du signal de l'horloge auxiliaire (10) dans la fenêtre centrale au début de la période de détermination, et des moyens (9) de détection du front montant considéré du signal de l'horloge auxiliaire (10) dans l'une ou l'autre des deux fenêtres latérales de la triple fenêtre.

4. Système selon l'une des revendications 1 à 3, dans lequel les moyens de décalage sont agencés pour, à partir du signal de retardement, compenser la dérive et recaler, toutes les N périodes T1, le signal de l'horloge interne (7) de la dérive d'amplitude To.

5. Système selon l'une des revendications 1 à 3, dans lequel les moyens de décalage sont agencés pour, à partir du signal de retardement, compenser toutes les PN périodes T1, le signal de l'horloge interne (7) d'une dérive d'amplitude PTo, P étant un nombre entier constant.

6. Système selon l'une des revendications 1 à 3, dans lequel les moyens de décalages sont agencés pour, à partir du signal de retardement, compenser la dérive de manière asynchrone et recaler, toutes les PN périodes T1, le signal de l'horloge interne (7) d'une dérive d'amplitude PTo, P étant un nombre entier variable.

**Patentansprüche**

1. Elektronisches System (1), das einen internen Taktgeber (7), der ein Signal mit der ungenauen Periode TI an eine Zeitbasis (6) liefert, sowie Mittel (8 - 14) zum Nachstellen des Zeitgebers aufweist, die vorgesehen sind, um in Kombination mit einem externen Bezugstaktgeber (3), der ein Signal mit der Periode To liefert, die Ungenauigkeit der Periode TI des Signals des internen Taktgebers (7) auszugleichen, dadurch gekennzeichnet, daß die Mittel zum Nachstellen des Taktgebers vorgesehen sind, um die Anzahl N von Perioden TI des Signals des internen Taktgebers (7) zu bestimmen, während derer das Signal des internen Taktgebers (7) einer Abweichung von einer Periode To bezüglich des Bezugssignals ausgesetzt war, und um zur Zeitbasis (6) ein Signal mit der Periode NT1 von Impulsen zu liefern, die dazu bestimmt sind, das von der Zeitbasis (6) gelieferte Signal um eine Dauer PTo zu verzögern, wobei P eine ganze Zahl größer oder gleich 1 ist.

2. System nach Anspruch 1, bei dem die Mittel zum Nachstellen des Taktgebers Mittel (8) zum Bestimmen der Anzahl N von Perioden TI aufweisen, nach deren Ablauf das Signal des internen Taktgebers (7) um eine Periode To bezüglich des Bezugssignals abgewichen ist, sowie Mittel (9-11) zum Bestimmen der Richtung der Abweichung.

3. System nach Anspruch 2, bei dem die Mittel zum Bestimmen der Richtung der Abweichung der Mittel zum Nachstellen einen Hilfstaktgeber (10) mit der Periode 3T1 aufweisen, die das Dreifache derjenigen des internen Taktgebers (7) ausmacht, Mittel (9) zum Erzeugen eines dreifachen Zeitfensters mit der Breite 3To mit einem zentralen Fenster und zwei seitlichen Fenstern jeweils mit einer Breite To sowie einer Vorderflanke des Signals des Hilfstaktgebers (10) in dem zentralen Fenster zu Beginn der Bestimmungsperiode sowie Mittel (9) zum Erfassen der betrachteten Vorderflanke des Signals des Hilfstaktgebers (10) in dem einen oder anderen der beiden seitlichen Fenster des Dreifachfensters.

4. System nach einem der Ansprüche 1 bis 3, bei dem die Mittel zum Nachstellen vorgesehen sind, um ausgehend von dem Verzögerungssignal die Abweichung auszugleichen und alle N Perioden TI das Signal des internen Taktgebers (7) der Abweichung mit der Amplitude To auszugleichen.

5. System nach einem der Ansprüche 1 bis 3, bei dem die Mittel zum Nachstellen vorgesehen sind, um ausgehend von dem Verzögerungssignal alle PN Perioden TI das Signal des internen Taktgebers (7) einer Abweichung mit der Amplitude PTo auszugleichen, wobei P eine konstante ganze Zahl ist.

6. System nach einem der Ansprüche 1 bis 3, bei dem die Mittel zum Nachstellen vorgesehen sind, um ausgehend von dem Verzögerungssignal asynchron die Abweichung auszugleichen und alle PN Perioden TI das Signal des internen Taktgebers (7) einer Abweichung mit der Amplitude PTo nachzustellen, wobei P eine variable ganze Zahl ist.

**Claims**

1. Electronic system (1) comprising an internal clock (7), supplying a signal of an imprecise period T1 to a time base (6), and means (8-14) for resetting the clock, arranged in order, in combination with an external reference clock (3) supplying a signal of a period To, to compensate for the impreciseness of the period T1 of the signal of the internal clock (7), characterised in that the clock resetting means are arranged to determine the number N of periods T1 of the signal of the internal clock (7) during which the signal of the internal clock (7) has undergone a drift of a period To with respect to the reference signal and in order to supply to the time base (6) a signal, of a period NT1, of pulses intended to retard, for a duration PTo, the clock signal supplied by the time base (6), P being an integer equal to or greater than 1.

2. System according to claim 1, wherein the clock resetting means comprise means (8) for determining the number N of periods T1 at the end of which the signal of the internal clock (7) has drifted by a period To with respect to the reference signal and means (9-11) for determining the direction of the drift.

3. System according to claim 2, wherein the means for determining the direction of the drift of the resetting means comprise an auxiliary clock (10) of a period 3T1 three times that of the internal clock (7), means (9) for creating a triple time window of a width 3To with a central window and two lateral windows each of a width To, and a rising leading edge of the signal of the auxiliary clock (10) in the central window at the beginning of the determination period, and means (9) for detecting the rising leading edge in question of the signal of the auxiliary clock (10) in one or other of the two lateral windows of the triple window.

4. System according to one of claims 1 to 3, wherein the resetting means are arranged in order, from the retardation signal, to compensate for the drift and to reset, all the N periods T1, the signal of the internal clock (7) with the drift of amplitude To.

5. System according to one of claims 1 to 3, wherein the resetting means are arranged in order, from the retardation signal, to compensate, for all the PN periods T1, the signal of the internal clock (7) a drift of amplitude PTo, P being a constant integer.

6. System according to one of claims 1 to 3, wherein the resetting means are arranged in order, from the retardation signal, to compensate for the drift in an asynchronous manner and to reset, all the PN periods T1, the signal of the internal clock (7) with a drift of amplitude PTo, P being a variable integer.

FIG.1A

FIG.1B

FIG.2A

FIG.2B

FIG.3

FIG.4